# FASCICULE DE BREVET EUROPEEN

(11) **EP 3 788 656 B1**
(45) Date de publication et mention de la délivrance du brevet: **11.09.2024**
(21) Numéro de dépôt: 19725959.1
(22) Date de dépôt: 16.05.2019
(51) Int. Cl.: H10N 60/30

(54) **LIMITEUR DE COURANT SUPRACONDUCTEUR AVEC ENTRETOISE ÉLECTRIQUEMENT CONDUCTRICE**
SUPRALEITENDER STROMBEGRENZER MIT ELEKTRISCH LEITENDEM ABSTANDSHALTER
SUPERCONDUCTING CURRENT LIMITER WITH ELECTRICALLY CONDUCTING SPACER

(30) Priorité: 17.05.2018 FR 1854132
(43) Date de publication de la demande: 10.03.2021
(73) Titulaire: Supergrid Institute, 69100 Villeurbanne (FR); Institut Polytechnique de Grenoble, 38000 Grenoble (FR)
(72) Inventeur: LEGENDRE, Pierre, 69007 Lyon (FR); TIXADOR, Pascal, 69007 Lyon (FR)
(74) Mandataire: Opilex
(86) Numéro de dépôt international: PCT/EP2019/062660
(87) Numéro de publication internationale: WO 2019/219835

(56) Documents cités:
- EP-A1- 2 117 056
- WO-A1-2008/006689
- JP-A- 2000 197 263

## Description

L'invention a trait au domaine des limiteurs de courant supraconducteurs, destinés à des applications sous haute tension.

Ces limiteurs de courant, qui peuvent être résistifs, sont constitués d'un ou plusieurs conducteur de type supraconducteur et sont, en fonctionnement normal, très faiblement résistifs. Lorsqu'un défaut électrique a pour conséquence une importante augmentation de la densité de courant dans le ou les conducteurs, ou lorsque ces derniers ne sont plus suffisamment refroidis, ils perdent leurs propriétés supraconductrices et le limiteur de courant devient alors fortement résistif, maintenant ainsi le courant en dessous d'une certaine valeur.

La longueur des conducteurs de type supraconducteur nécessaire au limiteur de courant est proportionnelle à la tension du réseau ou dispositif à protéger. Elle atteint plusieurs centaines de mètres, voire des kilomètres, pour un limiteur de courant prévu pour la haute tension. Les limiteurs de courant sont donc de préférence enroulés de manière compacte pour limiter l'encombrement d'un tel dispositif qui peut néanmoins atteindre plusieurs mètres de diamètre. Les enroulements des conducteurs supraconducteurs forment des bobines compactes pour lesquelles apparaissent des problématiques d'isolation.

Les demandes de brevet EP0503448 et EP0935261 décrivent un limiteur de courant comportant un conducteur supraconducteur enroulé sensiblement sous forme d'une spirale pour former une bobine bifilaire s'étendant selon un plan unique.

La demande de brevet EP2041809 décrit un dispositif supraconducteur limiteur de courant du type résistif, comprenant un enroulement de bobine bifilaire constitué d'un conducteur en ruban et des entretoises électriquement isolantes disposées entre deux spires de l'enroulement, l'entretoise étant perméable à un fluide frigorigène.

La demande de brevet EP1797599 décrit un dispositif limiteur de courant supraconducteur de type résistif comportant une bobine bifilaire dans laquelle, entre deux spires de la bobine, est maintenu un espace dans lequel peut passer un fluide de refroidissement. Cet espace est maintenu grâce à des entretoises électriquement isolantes qui sont collées aux rubans supraconducteurs.

La demande de brevet EP2289077 décrit un dispositif limiteur de courant supraconducteur de type résistif comportant une bobine bifilaire constituée de plusieurs rubans supraconducteurs. Dans certains de ses modes de réalisation, ce document décrit une entretoise isolante, perméable à un fluide de refroidissement, disposée entre deux spires qui sont au même potentiel électrique. Des autres exemples sont connus par JP 2000-197263 A et EP 2 117 056 A1.

L'invention a pour but d'améliorer les limiteurs de courant de l'art antérieur en proposant un agencement des conducteurs de type supraconducteur pour permettre au limiteur de courant de prendre en charge des courants élevés, en assurant un refroidissement performant du limiteur de courant, et ce pour des tensions de l'ordre de 50 à 2000 kV et des courants nominaux de l'ordre de 1000 A à 10000 A.

A cet effet, l'invention vise un limiteur de courant supraconducteur, comportant au moins un conducteur de type supraconducteur enroulé pour former une bobine s'étendant selon un plan unique et reliant un premier terminal de connexion électrique à un deuxième terminal de connexion électrique, une entretoise électriquement isolante étant disposée entre deux spires de la bobine. Le conducteur de type supraconducteur est constitué d'au moins deux câbles supraconducteurs distincts, enroulés parallèlement, dont les extrémités sont électriquement reliées respectivement par le premier terminal de connexion électrique et par le deuxième terminal de connexion électrique. Une entretoise électriquement conductrice est disposée entre deux desdits câbles supraconducteurs distincts, cette entretoise électriquement conductrice étant perméable à un fluide de refroidissement et assurant une continuité électrique entre les deux câbles supraconducteurs.

Un câble supraconducteur est un fil conducteur qui peut être d'une quelconque section, par exemple, ronde, ovale, ou rectangulaire, composé au moins partiellement d'un matériau supraconducteur. Il peut être constitué d'une âme recouverte d'un revêtement supraconducteur. Il peut avantageusement être constitué, au moins en partie, d'un des matériaux suivants :
- les matériaux dénommés « REBCO » (oxyde de terres rares, de baryum et de cuivre) : REBa₂Cu₃O₇₊ₓ, où RE représente un ou plusieurs éléments parmi Y et les terres rares (Gd, Nd, Dy, Eu, etc.) ;
- MgB₂ ;
- Bi₂Sr₂Ca₂Cu₃O₁₀₊ₓ ;
- tout autre matériau supraconducteur et adapté à la fabrication de câbles limiteurs de courant.

L'agencement du limiteur de courant supraconducteur selon l'invention vise à utiliser plusieurs câbles supraconducteurs mis en parallèle pour réaliser un conducteur de type supraconducteur. Le nombre de câbles supraconducteurs mis en parallèle est fonction du courant qui devra circuler dans le conducteur de type supraconducteur ainsi constitué. La mise en parallèle de plusieurs câbles supraconducteurs augmente le courant critique du conducteur de type supraconducteur ainsi formé. Le fait de faire passer le courant, prévu pour un conducteur, dans plusieurs câbles constituant ce conducteur permet par exemple d'utiliser des câbles supraconducteurs disponibles en tant que produits industriels standards mais sous-dimensionnés pour une application de fort courant. Une industrialisation de ce type de limiteurs de courant peut ainsi être envisagée, avec une réduction du coût et une simplification de la mise en oeuvre.

La structure du limiteur de courant supraconducteur assure un refroidissement efficace autour de chaque câble qui constituent un conducteur de type supraconducteur, et entre les spires de la bobine. Un fluide de refroidissement peut ainsi circuler entre tous les câbles supraconducteurs, aussi bien entre les câbles supraconducteurs de potentiels différents qu'entre les câbles supraconducteurs de même potentiel.

Au sein d'un même conducteur de type supraconducteur, les câbles supraconducteurs qui le constituent bénéficient de plus d'un transfert thermique performant grâce aux entretoises électriquement conductrices car les matériaux électriquement conducteurs présentent généralement également une meilleure conductivité thermique que les isolants électriques.

Lorsque plusieurs câbles sont utilisés conjointement pour faire circuler un courant, ces câbles étant au même potentiel, il est courant, dans l'art antérieur, de les regrouper ensemble dans une même gaine. Cependant, pour les applications utilisant un conducteur de type supraconducteur, le fait de juxtaposer, coller, ou souder des câbles supraconducteurs nuit au refroidissement de l'ensemble. Dans des applications en tant que limiteur de courant, le refroidissement est une fonction cruciale puisqu'elle conditionne directement à la fois la préservation du matériau (qui peut être détruit s'il chauffe trop) et le retour à l'état supraconducteur des câbles et donc le fonctionnement général du dispositif. Le temps de diffusion de la chaleur dans un matériau augmentant avec le carré de la distance, la juxtaposition de différents câbles supraconducteurs pour former un conducteur de type supraconducteur entrainerait une perte conséquente de capacité de refroidissement. Par exemple, si les câbles supraconducteurs sont des rubans, un empilement de cinq de ces rubans sera environ vingt-cinq fois moins performant qu'un seul de ces rubans pour ce qui est de transmettre de la chaleur transversalement dans cet empilement. Selon l'invention, au contraire, chaque câble supraconducteur est refroidi longitudinalement de part et d'autre, tout en étant maintenu au même potentiel électrique que les câbles supraconducteurs voisins qui font partie du même conducteur de type supraconducteur.

Par ailleurs, l'entretoise qui est disposée entre deux câbles supraconducteurs constituant un même conducteur, qui dans l'art antérieur isole électriquement les deux câbles, est ici utilisée, au contraire, pour assurer une connexion électrique entre ces câbles. Cette connexion électrique a lieu entre deux câbles qui sont au même potentiel électrique et n'est donc pas destinée à un passage du courant en régime continu. Cependant, en cas de défaut local sur un câble, le courant peut alors être dévié sur les câbles adjacents pour continuer sa progression dans le conducteur.

En effet, les câbles supraconducteurs adaptés pour une application de limiteur de courant présentent couramment des défauts appelés « points chauds », qui sont liés à une variation de leur degré d'homogénéité. Ces points chauds élèvent localement la température du câble supraconducteur et cette augmentation de température peut conduire à un endommagement irréversible du matériau. Par exemple, dans le cas de l'utilisation de rubans supraconducteurs dits « à haute température critique », tels que du type REBCO mentionnés ci-dessus, pour constituer un câble supraconducteur, la présence de points chauds est connue comme étant un point critique qui dégrade les performances générales du limiteur de courant. Grâce aux entretoises électriquement conductrices disposées entre les câbles supraconducteurs d'un même conducteur, non seulement le refroidissement de ces câbles est optimisé, mais un chemin de redondance possible est de surcroit offert pour le courant qui devrait transiter via un point chaud ou tout autre défaut et qui pourra ainsi le contourner.

Cet agencement du limiteur de courant ouvre également des possibilités pour optimiser l'encombrement du limiteur de courant. En effet, dans l'art antérieur, l'augmentation du courant critique est souvent réalisée par empilement de plusieurs enroulements, chacun s'étendant dans son plan respectif. L'invention donne le choix, lors de la conception, d'augmenter le nombre d'enroulements empilés, et/ou d'augmenter le nombre de câbles supraconducteurs qui forment tous les conducteurs, ou certains des conducteurs, de tous les enroulements empilés, ou seulement de certains de ces enroulements empilés. En fonction de l'encombrement disponible, la forme finale du limiteur de courant peut ainsi être optimisée en privilégiant la largeur ou la hauteur.

Le limiteur de courant peut comporter les caractéristiques additionnelles suivantes, seules ou en combinaison, le limiteur de courant selon l'invention étant défini par la revendication indépendante :
- la bobine est une bobine bifilaire ;
- le limiteur de courant comporte un espace interspire entre deux enroulements du conducteur de type supraconducteur, et comporte un espace intercâble entre deux câbles supraconducteurs du même conducteur de type supraconducteur, l'entretoise électriquement isolante étant disposée le long de l'espace interspire et l'entretoise électriquement conductrice étant disposée le long de l'espace intercâble ;
- l'entretoise électriquement conductrice est en métal ;
- l'entretoise électriquement conductrice est constituée d'un matériau semi-conducteur ;
- le métal de l'entretoise électriquement conductrice présente une conductivité thermique supérieure à 150 W/m/K ;
- l'entretoise électriquement conductrice a une forme de ruban plissé ou ondulé ;
- l'entretoise électriquement conductrice comporte des interstices de passage pour le fluide de refroidissement ;
- l'entretoise électriquement conductrice et l'entretoise électriquement isolante présentent sensiblement la même forme ;
- l'entretoise électriquement conductrice présente un comportement de conduction électrique anisotrope favorisant la conduction électrique entre lesdits deux câbles supraconducteurs ;
- l'entretoise électriquement conductrice est discontinue et formée d'espaceurs discrets ;
- l'entretoise électriquement conductrice est formée d'une juxtaposition d'espaceurs conducteurs et d'espaceurs isolants ;
- l'entretoise électriquement conductrice comporte des ponts métalliques entre lesdits deux câbles supraconducteurs et des traverses disposées entre ces ponts métalliques ;
- les traverses sont électriquement conductrices ;
- les traverses sont électriquement isolantes ;
- le limiteur de courant comporte en outre un dispositif de refroidissement comprenant un fluide de refroidissement en contact avec les entretoise électriquement isolantes, entre les spires de la bobine, et avec les entretoises électriquement conductrices, entre les câbles supraconducteurs ;
- l'entretoise conductrice comporte des semelles ou des socles augmentant la surface de contact avec les deux câbles supraconducteurs ;
- l'entretoise conductrice comporte des échangeurs de chaleur pour l'échange de chaleur avec le fluide de refroidissement.

Des exemples préférés de réalisation de l'invention vont maintenant être décrits en référence aux dessins annexés dans lesquels :
- la figure 1 représente schématiquement un limiteur de courant selon l'invention, formé d'un empilement de bobines ;
- la figure 2 représente schématiquement l'une des bobines, vue de dessus, du limiteur de courant de la figure 1 ;
- la figure 3 est une vue schématique agrandie du cadre III de la figure 2 ;
- la figure 4 est une vue schématique agrandie du cadre IV visible aux figures 2 et 3 ;
- la figure 5 est une vue schématique partielle en perspective d'un empilement de câbles supraconducteurs de la bobine de la figure 2 ;
- la figure 6 est une vue de détail de la figure 5, montrant une situation de passage du courant dans le cas d'un défaut local de type point chaud ;
- les figures 7 à 20 illustrent des variantes de réalisation des entretoises conductrices montrées aux figures 4 à 6 ;
- la figure 21 représente une variante de bobine, vue de dessus, pour le limiteur de courant de la figure 1.

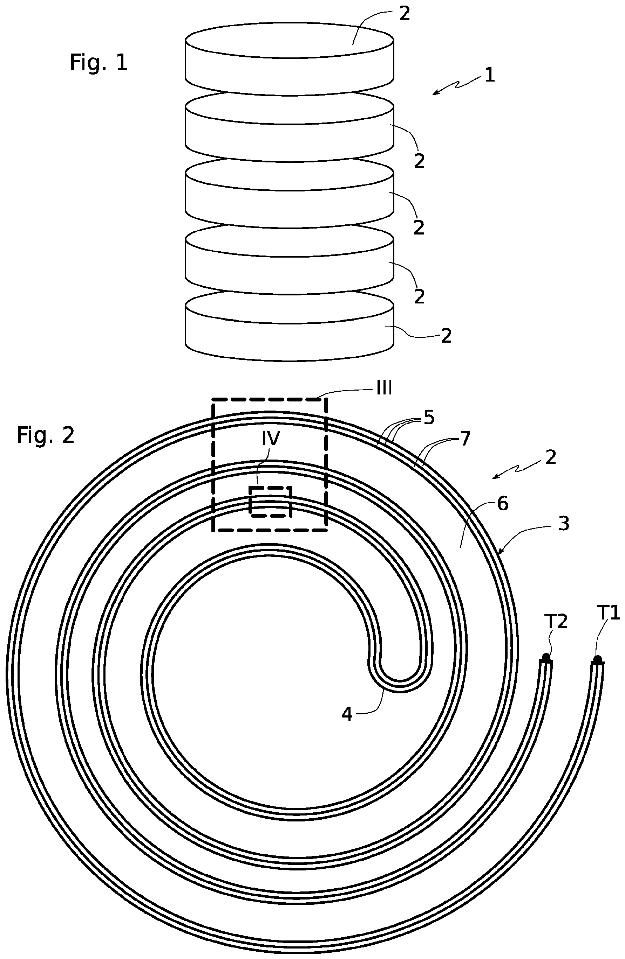

La figure 1 représente schématiquement un limiteur de courant supraconducteur selon l'invention. Ce limiteur de courant 1 comporte au moins une bobine formée d'au moins un conducteur de type supraconducteur enroulé selon un plan unique. Dans l'exemple de la figure 1, le limiteur de courant 1 comporte cinq bobines empilées. Le limiteur de courant 1 comporte autant de bobines 2 que nécessaire en fonction du courant et de la tension à prendre en charge.

La figure 2 représente schématiquement, vue de dessus, l'une des bobines 2 constituant le limiteur de courant 1. La bobine 2 est ici un dipôle comportant un premier terminal de connexion T1 et un deuxième terminal de connexion T2. Si la bobine 2 est l'unique bobine du limiteur de courant 1, les terminaux de connexion T1 et T2 sont les bornes du limiteur de courant 1 par lesquelles il sera raccordé au circuit électrique à protéger. Si le limiteur de courant 1 comporte, comme dans l'exemple de la figure 1, plusieurs bobines 2, celles-ci seront mises en série et/ou en parallèle par une connexion adéquate de leurs terminaux de connexion T1, T2 respectifs.

Dans le présente exemple, les bobines 3 sont des bobines bifilaires, c'est-à-dire que le conducteur les constituant fait un ou plusieurs allers-retours entre la périphérie de la bobine et le centre de la bobine.

Dans la bobine 2, un conducteur 3 de type supraconducteur relie le premier terminal de connexion T1 au deuxième terminal de connexion T2 en formant un enroulement. Dans cet exemple simplifié, le conducteur 3 part du premier terminal de connexion T1, s'enroule en formant deux spires puis, au centre de la spirale, forme un coude 4 pour ensuite former à nouveau deux spires et, à la périphérie de la spirale, rejoint le deuxième terminal de connexion T2.

Dans l'exemple de la figure 2, qui est un exemple simplifié pour les besoins de la description, la bobine 2 comporte un seul conducteur 3 de type supraconducteur et ses deux terminaux T1, T2, le conducteur 3 étant formé de trois câbles supraconducteurs 5 assemblés. Les trois câbles supraconducteurs 5 comportent chacun une première et une seconde extrémité, les trois premières extrémités étant reliées ensemble au niveau du premier terminal T1 et les trois secondes extrémités étant reliées ensemble au niveau du deuxième terminal T2. Les trois câbles supraconducteurs 5 constituant le conducteur 3 sont enroulés parallèlement dans la bobine bifilaire.

La longueur du conducteur de type supraconducteur, et donc le nombre de spires de l'enroulement, est également simplifiée sur les dessins. A titre d'exemple, pour un limiteur de courant ou une portion de limiteur de courant prévu pour 25 kV et dont le conducteur de type supraconducteur a une résistance linéique permettant une chute de tension de 50 V/m lorsqu'il devient résistif, ce conducteur devra avoir une longueur de l'ordre de 500 m, ce qui conduit à une bobine de plusieurs mètres de diamètre et à un très grand nombre de tours.

Les espaces situés entre deux spires de la bobine 2, c'est-à-dire les espaces entre deux tours du conducteur 3, sont dénommés « espaces interspire 6 ». Les espaces situés entre deux câbles supraconducteurs 5, au sein du conducteur 3, sont dénommés « espaces intercâble 7 ».

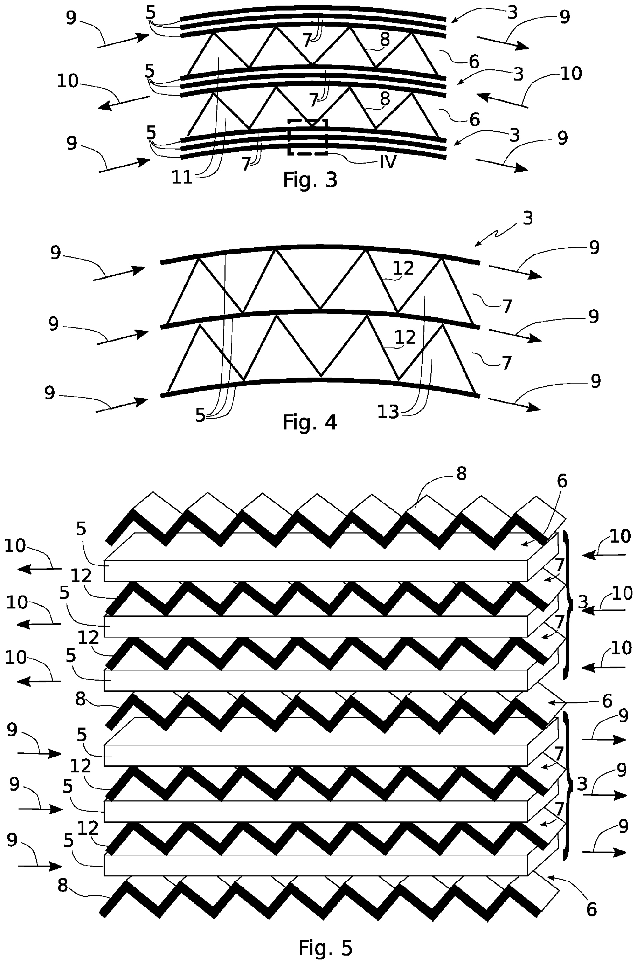

Les espaces interspires 6 comportent des entretoises électriquement isolantes et les espaces intercâbles 7 comportent des entretoises électriquement conductrices. Ces entretoises n'ont pas été représentées sur la vue simplifiée de la figure 2 et seront décrites ci-après en références aux figures 3 à 5.

La figure 3 est une vue agrandie du cadre III visible à la figure 2. Sur la figure 3 apparaissent donc trois portions de spires du conducteur 3. Entre chaque spire du conducteur 3 est disposée une couche d'isolant constituée d'une entretoise électriquement isolante 8. Dans cet exemple, un courant circule du premier terminal de connexion T1 vers le deuxième terminal de connexion T2 et des flèches représentent, sur la figure 3, le sens de passage de ce courant. Bien que le courant circule, dans cet exemple, toujours dans le même sens le long du conducteur 3, l'enroulement en bobine entraine la formation de spires de sorte qu'entre une portion du conducteur 3 et une autre portion du conducteur 3 située sur une spire adjacente, le courant circule en sens inverse. Pour les portions du conducteur 3 ou des câbles 5 représentés, la circulation du courant dans un sens (de la gauche vers la droite sur les figures) sera schématisée par les flèches 9, tandis que la circulation du courant dans l'autre sens (de la droite vers la gauche) sera schématisée par des flèches 10. Sur la portion de spire du haut de la figure 3, le courant circule de la gauche vers la droite selon les flèches 9 ; sur la portion de spire du milieu, le courant circule de la droite vers la gauche selon les flèches 10 ; et sur la portion de spire du bas, le courant circule de la gauche vers la droite selon les flèches 9.

L'entretoise isolante 8 présente une forme adaptée à maintenir l'espace interspire 6, à isoler électriquement les deux spires adjacentes correspondantes, et à être perméable à un fluide de refroidissement. L'entretoise isolante 8 est réalisée par un quelconque matériau isolant suffisamment rigide pour permettre le maintien de l'écartement de l'espace interspire 6. L'entretoise isolante 8 est ici réalisée par une feuille de matériau isolant plissée, c'est à dire pliée en triangle, ou ondulée, ce qui ménage des interstices 11 permettant le passage du fluide de refroidissement.

Le limiteur de courant 1 est refroidi à la température adéquate pour le maintien des propriétés supraconductrices du conducteur 3. La ou les bobines 2 sont ainsi baignées dans un fluide tel que de l'azote liquide, ou ce fluide est mis en circulation par un circuit de refroidissement. Ce fluide de refroidissement est en contact avec le conducteur 3 grâce aux interstices 11 des entretoises isolantes 8 et grâce aux interstices 13 des entretoises conductrices 12.

La figure 4 est un agrandissement du cadre IV visible aux figures 2 et 3. Cet agrandissement représente une portion du conducteur 3. Dans les trois câbles 5 constituant le conducteur 3, le sens 9 de circulation du courant est le même. Des entretoises conductrices 12 sont disposées entre ces câbles 5, au sein du conducteur 3, dans les espaces intercâbles 7.

Les entretoises conductrices 12 ont trois fonctions :
- maintenir l'écartement entre deux câbles 5 ;
- conduire le courant entre les deux câbles 5 ;
- être perméables au fluide de refroidissement.

Les entretoises conductrices 12 ont structurellement la même forme, dans le présent exemple, que l'entretoise isolante 8 et présentent des interstices 13 permettant le passage du fluide de refroidissement et les échanges thermiques directement avec les câbles 5 et indirectement via les entretoises conductrices 12.

Les entretoises conductrices 12 sont réalisées dans un matériau électriquement conducteur, par exemple un métal ou un matériau semi-conducteur. Les entretoises conductrices 12 sont chacune en contact avec deux câbles 5 et assurent ainsi une continuité électrique entre ces deux câbles 5. En régime permanent, les câbles 5 ont des propriétés supraconductrices tandis que les entretoises conductrices 12 ont les propriétés d'un conducteur classique. Le courant va donc de préférence passer dans les câbles supraconducteurs 5, qui présentent une résistance quasi-nulle, plutôt que dans les entretoises conductrices 12 qui, bien que conductrices, présentent une certaine résistance. Les entretoises conductrices 12 vont cependant équilibrer la répartition du courant ainsi que les potentiels et garantir qu'une importante différence de potentiel entre deux câbles supraconducteurs 5 du même conducteur 3 ne puisse se développer.

Le refroidissement de l'ensemble de la bobine 2 est assuré par le même fluide de refroidissement qui passe aussi bien au travers des entretoises isolantes 8 qu'au travers des entretoises conductrices 12. Le métal constituant les entretoises conductrices est de préférence un métal présentant une forte conductivité thermique, par exemple supérieure à 150 W/m/K, tel que le cuivre ou l'aluminium. Les fonctions de conductivité thermique et de conductivité électrique sont ainsi assurées de manière optimale par les entretoises conductrices 12.

On utilisera avantageusement des géométries d'entretoises conductrices 12 qui optimisent les échanges thermiques entre les entretoises conductrices 12 et le fluide de refroidissement, et qui optimisent les échanges thermiques et la conduction électrique entre deux câbles 5. En particulier, des structures à ailettes peuvent être employées, ainsi que toute méthode réduisant les résistances de contact.

La figure 5 illustre schématiquement une portion de la bobine 2 montrant deux spires adjacentes du conducteur 3 et l'agencement des entretoises isolantes 8 et conductrices 12. Sur cette figure, les espaces interspire 6 et les espaces intercâble 7 présentent le même écartement. L'entretoise isolante 8 et les entretoises conductrices 12 ont ici la même forme, les mêmes dimensions, et diffèrent par leur matériau de constitution, respectivement isolant et électriquement conducteur. En variante, les tailles d'entretoises 8 et 12 peuvent être différentes entre elles si l'on souhaite réaliser des espacements variables entre les câbles 3 et/ou entre les conducteurs 5, au sein de la bobine.

Dans la représentation tridimensionnelle schématique de la figure 5, les câbles supraconducteurs 5 constituant le conducteur 3 sont des rubans supraconducteurs classiques, par exemple des rubans de type REBCO. L'entretoise isolante 8 et les entretoises conductrices 12 sont des rubans plissés.

La figure 5 représente donc : sur le haut de la figure, une première portion du conducteur 3, avec les trois portions de câbles 5 le constituant ; et sur le bas de la figure, une deuxième portion du conducteur 3, correspondant à la spire adjacente, avec les trois portions de câbles 5 le constituant. Deux portions d'entretoises conductrices 12 apparaissent au sein de chaque conducteur 3, entre les câbles 5. Une portion d'entretoise isolante 8 est visible entre les deux conducteurs 3, ainsi qu'au-dessus de la portion du conducteur 3 du dessus, et en dessous de la portion du conducteur 3 du dessous, pour la coopération avec les spires adjacentes non représentées.

Cet empilement de câbles supraconducteurs 5 et d'entretoise 8, 12 est traversé par le fluide de refroidissement.

Dans les câbles 5 de la portion du conducteur 3 du dessus, le courant circule dans le sens 10 tandis que dans les câbles 5 de la portion de conducteur 3 du dessous, le courant circule dans le sens 9. Les sens 9 et 10 de circulation du courant ont été représentés pour chaque câble supraconducteur 5.

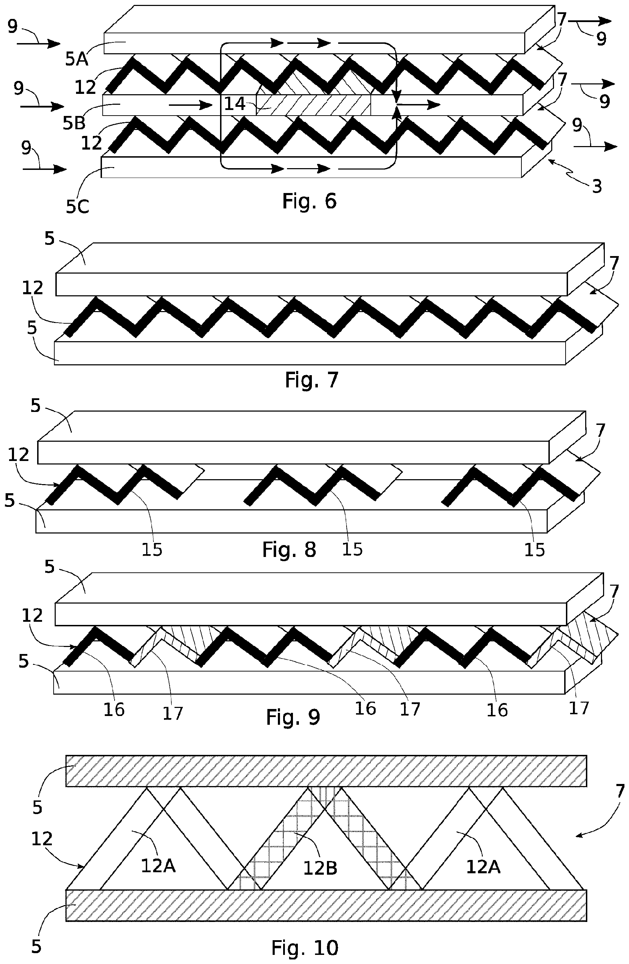

La figure 6 représente une portion du conducteur 3 et montre les trois câbles 5A, 5B, 5C le constituant, ainsi que les deux entretoises conductrices 12 maintenant l'écart et la conductivité électrique entre ces trois câbles 5. Le courant circule dans le sens des flèches 9. Cette figure 6 illustre le comportement du conducteur 3 en cas d'apparition d'un point chaud 14.

Dans cet exemple, le point chaud 14 apparait sur le câble 5B du milieu. En amont du point chaud 14, le courant circule de la même manière dans les câbles 5A, 5B, 5C en bénéficiant de leurs propriétés supraconductrices. Sur le câble 5B, le courant, en arrivant au point chaud 14, ne bénéficie plus des propriétés supraconductrices du câble qui peut même devenir fortement résistif localement.

En amont du point chaud 14, au moins une partie du courant va être déviée par les entretoises conductrices 12 et va ainsi contourner le point chaud 14 par les autres câbles 5A, 5C. En aval du point chaud 14, les entretoises conductrices équilibrent les courants en permettant à une portion du courant de revenir dans le câble 5B.

Les figures 7 à 20 sont relatives à des variantes de réalisation des entretoises conductrices 12. Dans les différents modes de réalisation et variantes, les éléments ayant la même fonction portent le même numéro de renvoi aux figures.

La figure 7 est une vue simplifiée montrant une portion comportant deux câbles supraconducteurs 5 d'un même conducteur 3 et l'entretoise conductrice 12 disposée entre ces deux câbles 5. La figure 7 illustre la réalisation des entretoises conductrices 12 décrites aux figures 5 et 6. L'entretoise conductrice 12 de la figure 7 est donc constituée d'un ruban plissé métallique en contact, de part et d'autre, avec les deux câbles 5.

La variante de la figure 8 illustre un cas où l'entretoise conductrice 12 est discontinue. Elle est formée de plusieurs espaceurs 15 discrets répartis sur toute la longueur de l'espace intercâble 7. L'entretoise conductrice 12 assure donc la conduction électrique entre les deux câbles 5, notamment pour équilibrer les courants et contourner un éventuel point chaud. Cependant, l'entretoise conductrice 12 ne peut participer à la conduction du courant que sur certaines portions de la longueur de l'espace intercâble 7, ce qui procure à l'entretoise conductrice 12 un comportement de conduction électrique anisotrope, c'est-à-dire présentant une conductivité importante entre deux câbles 5 mais une conductivité faible voire nulle dans le sens de circulation du courant le long des câbles 5.

Ce comportement de conduction anisotrope évite une trop grande réduction de la résistance électrique de la bobine 2 lorsqu'elle est en mode de limitation de courant.

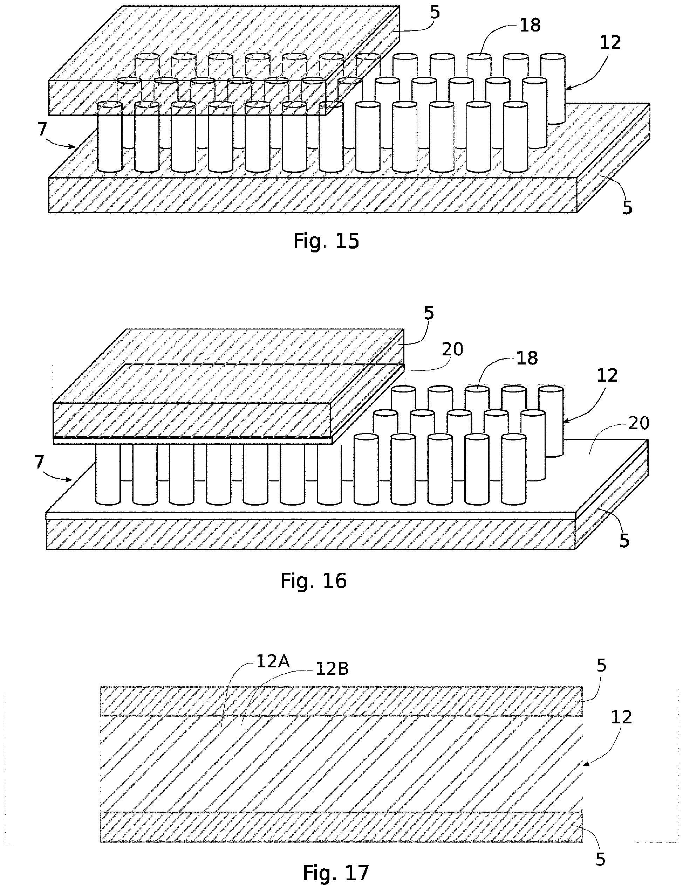

La figure 9 illustre une autre variante pour l'entretoise conductrice 12 lui procurant un comportement de conduction électrique anisotrope. Selon cette variante de la figure 9, l'entretoise conductrice 12 est réalisée à partir d'un assemblage d'espaceurs métalliques 16 et d'espaceurs isolants 17 (représentés hachurés sur la figure 17) disposés en alternance le long de l'espace intercâble 7. L'entretoise conductrice 12 assure ainsi un espacement sur toute la longueur de l'espace intercâble 7 tout en limitant la circulation du courant le long de l'entretoise conductrice 12 grâce aux espaceurs isolants 17, qui sont par exemple constitués d'un polymère électriquement isolant.

La figure 10 illustre une variante similaire à la variante de la figure 9, où l'entretoise conductrice 12 est constituée d'une alternance d'une portion conductrice 12A (en V inversé, sur la figure) et d'une portion isolante 12B (en V inversé).

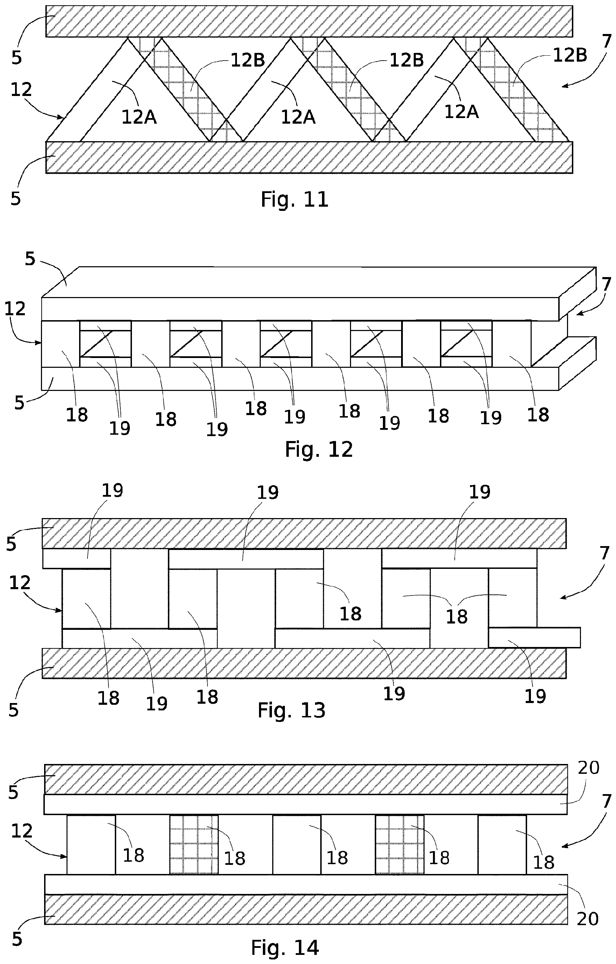

La figure 11 représente une autre variante où l'alternance des portions conductrices et isolantes est réalisée par le fait que l'une 12A des branches du V inversé est conductrice, et que l'autre branche 12B est isolante.

La figure 12 illustre une autre variante pour la réalisation de l'entretoise conductrice 12 lui procurant également un comportement de conduction électrique anisotrope. L'entretoise conductrice 12 est ici réalisée par une succession de ponts 18 métalliques et de traverses 19 disposées entre ces ponts 18. Les ponts métalliques 18 assurent la conductivité électrique entre les câbles 5 et les traverses 19 maintiennent les ponts 18 en position. Les traverses 19 peuvent être réalisées en matériau isolant et le comportement de l'entretoise conductrice 12 sera alors similaire à celui de la variante de la figure 9. Les traverses 19 peuvent également être en matériau conducteur, par exemple métallique, l'entretoise conductrice 12 présentant alors quand même un comportement anisotrope, préservant la conduction entre les câbles 5 tout en la réduisant le long de l'espace intercâble 7.

La figure 13 illustre une disposition alternative des traverses 19 dans laquelle les traverses 19 relient chacune deux ponts 18, les traverses 19 du haut étant disposées en quinconce par rapport aux traverses 19 du bas.

La figure 14 illustre une variante où les ponts 18 sont reliés par des semelles 20 respectivement au câble 5 du haut et au câble 5 du bas. Optionnellement, certains des ponts 18 (ici un sur deux) sont isolants (les ponts 18 isolants sont représentés hachurés).

Les figures 15 et 16 illustrent des variantes où les ponts 18 sont constitués pas des cylindres reliant les deux câbles 5. Dans la variante de la figure 15, les ponts 18 relient directement les câbles 5. Dans la variante de la figure 16, les ponts 18 relient les câbles 5 par l'intermédiaire d'une semelle 20 disposée contre chacun des câbles 5.

Les semelles 20 des figures 14 et 16 augmentent par ailleurs la surface de contact entre l'entretoise conductrice 12 et les câbles 5 et favorisent ainsi l'échange thermique, ce qui rend plus performant le refroidissement des câbles 5 par le fluide de refroidissement.

La figure 17 illustre un autre mode de réalisation dans lequel l'entretoise isolante 12 est constituée d'un matériau formé de couches conductrices 12A et de couches isolantes 12B, en alternance.

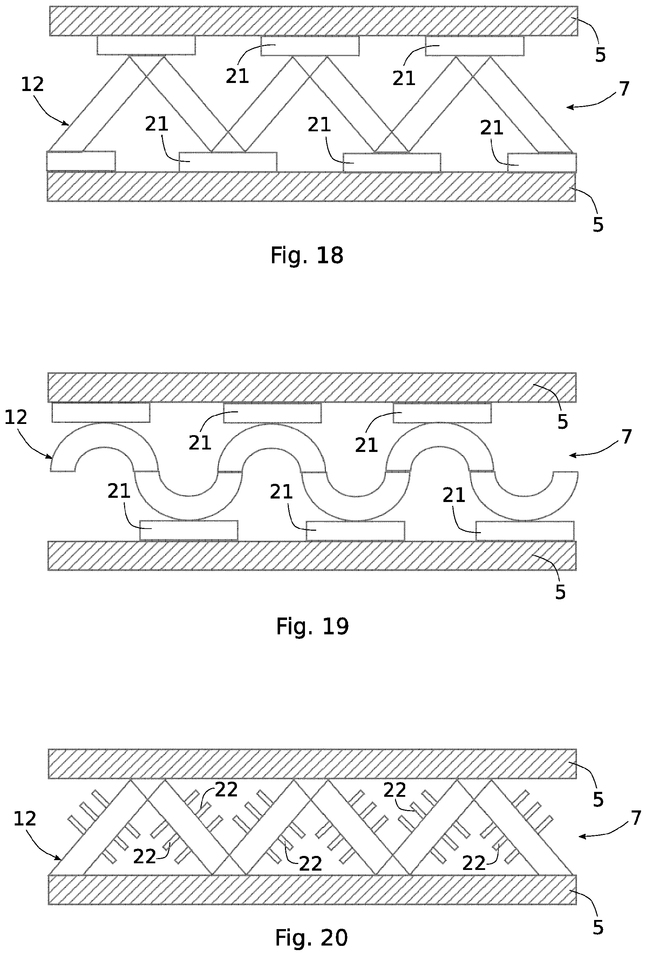

Les figures 18 à 20 illustrent des variantes de l'entretoise conductrice 12 relatives à la capacité d'échange thermique de l'entretoise conductrice 12.

La figure 18 illustre une variante de l'entretoise conductrice 12 de la figure 7. Selon cette variante, l'entretoise conductrice 12 comporte des socles 21 rattachant les sommets des plis constituant l'entretoise 12 aux câbles 5. Ces socles 21 augmentent la surface de contact entre l'entretoise conductrice 12 et les câbles 5 et favorisent ainsi l'échange thermique, ce qui rend plus performant le refroidissement des câbles 5 par le fluide de refroidissement.

La figure 19 est similaire à la figure 18, l'entretoise conductrice 12 étant ici ondulée. Optionnellement, cette forme ondulée de l'entretoise 12 peut être prévue sans les socles 21.

La figure 20 illustre une variante de l'entretoise conductrice 7, dans laquelle l'entretoise 12 comporte un échangeur de chaleur supplémentaire constitué d'ailettes 22 qui augmentent la surface de contact avec le fluide de refroidissement. L'échangeur de chaleur supplémentaire est ici défini comme un dispositif d'augmentation de la surface d'échange de l'entretoise 12.

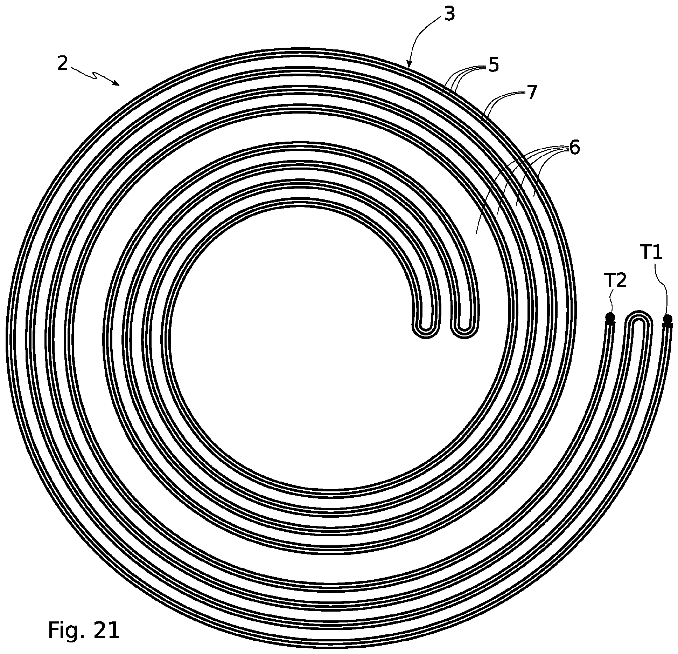

La figure 21 illustre une variante de réalisation de la bobine 2 adaptée à constituer un limiteur de courant 1. Selon cette variante, le conducteur 3 de type supraconducteur est agencé pour réaliser deux allers-retours entre la périphérie de la bobine et le centre de la bobine. Quel que soit l'agencement et le nombre des conducteurs 3, des entretoises conductrices sont disposées dans les espaces intercâble 7 et des entretoises isolantes sont disposées dans les espaces interspire 6.

D'autres variantes de réalisation du limiteur de courant peuvent être envisagées sans sortir du cadre de l'invention. Par exemple, un conducteur de type supraconducteur du limiteur de courant peut comporter un nombre quelconque de câbles supraconducteurs pour le constituer, une ou plusieurs entretoise conductrice étant disposée entre ces câbles ou groupes de câbles.

De même, une bobine peut comporter un nombre quelconque de conducteurs de type supraconducteurs enroulés pour former la bobine et le nombre correspondant de terminaux de connexion, une ou plusieurs entretoise isolante étant disposée pour séparer chaque spire formée par ces différents conducteurs de type supraconducteurs.

La bobine peut être tout type de bobine, bifilaire ou non. Elle peut être de forme cylindrique, ovale, ou rectangulaire.

Le limiteur de courant peut également comporter un nombre quelconque de bobines empilées, dont les terminaux de connexion sont reliés entre eux, en série ou en parallèle.

Le matériau et la forme des entretoises conductrices peut varier tout en permettant aussi bien la conduction électrique sur au moins des portions de l'entretoise conductrice, que la perméabilité au fluide de refroidissement. Les entretoises conductrices peuvent être réalisées dans un matériau conducteur poreux, ou comporter des conduits de circulation du fluide de refroidissement, par exemple.

Le comportement de conduction électrique anisotrope peut être procuré aux entretoises électriquement conductrices par d'autres moyens tels que grâce à des matériaux cristallins intrinsèquement anisotropes. On utilisera ces matériaux avantageusement en les disposant de sorte qu'ils aient une conduction électrique supérieure dans le sens transversal, c'est-à-dire entre deux câbles 3, que dans le sens longitudinal, c'est-à-dire le long des espaces intercâbles 7.

Les différents modes de réalisation et variantes de l'entretoise conductrice 12 peuvent être combinés.

## Revendications

1. Limiteur de courant (1) supraconducteur, comportant au moins un conducteur de type supraconducteur (3) enroulé pour former une bobine (2) s'étendant selon un plan unique et reliant un premier terminal de connexion électrique (T1) à un deuxième terminal de connexion électrique (T2), une entretoise électriquement isolante (8) étant disposée entre deux spires de la bobine (2), dont le conducteur de type supraconducteur (3) est constitué d'au moins deux câbles supraconducteurs (5) distincts, enroulés parallèlement, dont les extrémités sont électriquement reliées respectivement par le premier terminal de connexion électrique (T1) et par le deuxième terminal de connexion électrique (T2) ; et une entretoise électriquement conductrice (12) disposée entre deux desdits câbles supraconducteurs (5) distincts, cette entretoise électriquement conductrice (12) étant perméable à un fluide de refroidissement, **caractérisé par** l'entretoise électriquement conductrice (12) assurant une continuité électrique entre ces deux câbles supraconducteurs (5).

2. Limiteur de courant selon la revendication 1, **caractérisé en ce que** la bobine (2) est une bobine bifilaire.

3. Limiteur de courant selon l'une quelconque des revendications précédentes, **caractérisé en ce qu'**il comporte un espace interspire (6) entre deux enroulements du conducteur de type supraconducteur (3), et **en ce qu'**il comporte un espace intercâble (7) entre deux câbles supraconducteurs (5) du même conducteur de type supraconducteur (3), l'entretoise électriquement isolante (8) étant disposée le long de l'espace interspire (6) et l'entretoise électriquement conductrice (12) étant disposée le long de l'espace intercâble (7).

4. Limiteur de courant selon l'une quelconque des revendications précédentes, **caractérisé en ce que** l'entretoise électriquement conductrice (12) est en métal.

5. Limiteur de courant selon l'une des revendications 1 à 3, **caractérisé en ce que** l'entretoise électriquement conductrice (12) est constituée d'un matériau semi-conducteur.

6. Limiteur de courant selon la revendication 5, **caractérisé en ce que** le métal de l'entretoise électriquement conductrice (12) présente une conductivité thermique supérieure à 150 W/m/K.

7. Limiteur de courant selon l'une des revendications précédentes, **caractérisé en ce que** l'entretoise électriquement conductrice (12) a une forme de ruban plissé ou ondulé.

8. Limiteur de courant selon l'une quelconque des revendications précédentes, **caractérisé en ce que** l'entretoise électriquement conductrice (12) comporte des interstices (13) de passage pour le fluide de refroidissement.

9. Limiteur de courant selon l'une quelconque des revendications précédentes, **caractérisé en ce que** l'entretoise électriquement conductrice (12) et l'entretoise électriquement isolante (8) présentent sensiblement la même forme.

10. Limiteur de courant selon l'une quelconque des revendications précédentes, **caractérisé en ce que** l'entretoise électriquement conductrice (12) présente un comportement de conduction électrique anisotrope favorisant la conduction électrique entre lesdits deux câbles supraconducteurs (5).

11. Limiteur de courant selon la revendication 10, **caractérisé en ce que** l'entretoise électriquement conductrice (12) est discontinue et formée d'espaceurs discrets (15).

12. Limiteur de courant selon la revendication 10, **caractérisé en ce que** l'entretoise électriquement conductrice (12) est formée d'une juxtaposition d'espaceurs conducteurs (16) et d'espaceurs isolants (17).

13. Limiteur de courant selon la revendication 10, **caractérisé en ce que** l'entretoise électriquement conductrice (12) comporte des ponts métalliques (18) entre lesdits deux câbles supraconducteurs (5) et des traverses (19) disposées entre ces ponts métalliques.

14. Limiteur de courant selon la revendication 13, **caractérisé en ce que** les traverses (19) sont électriquement conductrices.

15. Limiteur de courant selon la revendication 13, **caractérisé en ce que** les traverses (19) sont électriquement isolantes.

16. Limiteur de courant selon l'une quelconque des revendications précédentes, **caractérisé en ce qu'**il comporte en outre un dispositif de refroidissement comprenant un fluide de refroidissement en contact avec les entretoises électriquement isolantes (8), entre les spires de la bobine (2), et avec les entretoises électriquement conductrices (9), entre les câbles supraconducteurs (5).

17. Limiteur de courant selon l'une quelconque des revendications précédentes, **caractérisé en ce que** l'entretoise conductrice (12) comporte des semelles (20) ou des socles (21) augmentant la surface de contact avec les deux câbles supraconducteurs (5).

18. Limiteur de courant selon l'une quelconque des revendications précédentes, **caractérisé en ce que** l'entretoise conductrice (12) comporte des échangeurs de chaleur (22) supplémentaires pour l'échange de chaleur avec le fluide de refroidissement.

## Patentansprüche

1. Supraleitender Strombegrenzer (1), der mindestens einen supraleitenden Leiter (3) umfasst, der aufgewickelt ist, um eine Spule (2) zu bilden, die sich in einer einzigen Ebene erstreckt und eine erste elektrische Anschlussklemme (T1) mit einer zweiten elektrischen Anschlussklemme (T2) verbindet, wobei zwischen zwei Windungen der Spule (2) ein elektrisch isolierender Abstandshalter (8) angeordnet ist, dessen supraleitender Leiter (3) aus mindestens zwei separaten, parallel gewickelten supraleitenden Kabeln (5) gebildet ist, deren Enden jeweils durch die erste elektrische Anschlussklemme (T1) und die zweite elektrische Anschlussklemme (T2) elektrisch verbunden sind; und einen elektrisch leitenden Abstandshalter (12), der zwischen zwei der separaten supraleitenden Kabel (5) angeordnet ist, wobei dieser elektrisch leitende Abstandshalter (12) für ein Kühlfluid durchlässig ist, **dadurch gekennzeichnet, dass** der elektrisch leitende Abstandshalter (12) eine elektrische Kontinuität zwischen diesen beiden supraleitenden Kabeln (5) sicherstellt.

2. Strombegrenzer nach Anspruch 1, **dadurch gekennzeichnet, dass** die Spule (2) eine zweiadrige Spule ist.

3. Strombegrenzer nach einem der vorstehenden Ansprüche, **dadurch gekennzeichnet, dass** er einen Raum (6) zwischen zwei Windungen des supraleitenden Leiters (3) umfasst, und dass er einen Zwischenleitungsspalt (7) zwischen zwei supraleitenden Kabeln (5) desselben supraleitenden Leiters (3) umfasst, wobei der elektrisch isolierende Abstandshalter (8) entlang des Raums (6) zwischen Windungen angeordnet ist und der elektrisch leitende Abstandshalter (12) entlang des Raums (7) zwischen Kabel angeordnet ist.

4. Strombegrenzer nach einem der vorstehenden Ansprüche, **dadurch gekennzeichnet, dass** der elektrisch leitende Abstandshalter (12) aus Metall besteht.

5. Strombegrenzer nach einem der Ansprüche 1 bis 3, **dadurch gekennzeichnet, dass** der elektrisch leitende Abstandshalter (12) aus einem Halbleitermaterial besteht.

6. Strombegrenzer nach Anspruch 5, **dadurch gekennzeichnet, dass** das Metall des elektrisch leitenden Abstandshalters (12) eine Wärmeleitfähigkeit größer als 150 W/m/K aufweist.

7. Strombegrenzer nach einem der vorstehenden Ansprüche, **dadurch gekennzeichnet, dass** der elektrisch leitende Abstandshalter (12) die Form eines gefalteten oder gewellten Bandes aufweist.

8. Strombegrenzer nach einem der vorstehenden Ansprüche, **dadurch gekennzeichnet, dass** der elektrisch leitende Abstandshalter (12) Durchgangslücken (13) für das Kühlfluid aufweist.

9. Strombegrenzer nach einem der vorstehenden Ansprüche, **dadurch gekennzeichnet, dass** der elektrisch leitende Abstandshalter (12) und der elektrisch isolierende Abstandshalter (8) im Wesentlichen die gleiche Form aufweisen.

10. Strombegrenzer nach einem der vorstehenden Ansprüche, **dadurch gekennzeichnet, dass** der elektrisch leitende Abstandshalter (12) ein anisotropes elektrisches Leitungsverhalten aufweist, das die elektrische Leitung zwischen den beiden supraleitenden Kabeln (5) fördert.

11. Strombegrenzer nach Anspruch 10, **dadurch gekennzeichnet, dass** der elektrisch leitende Abstandshalter (12) diskontinuierlich ist und aus separaten Beabstandungselementen (15) gebildet ist.

12. Strombegrenzer nach Anspruch 10, **dadurch gekennzeichnet, dass** der elektrisch leitende Abstandshalter (12) aus einer Nebeneinanderstellung leitenden Beabstandungselemente (16) und isolierenden Beabstandungselementen (17) gebildet ist.

13. Strombegrenzer nach Anspruch 10, **dadurch gekennzeichnet, dass** der elektrisch leitende Abstandshalter (12) Metallbrücken (18) zwischen den beiden supraleitenden Kabeln (5) und Querstreben (19), die zwischen diesen Metallbrücken angeordnet sind, aufweist.

14. Strombegrenzer nach Anspruch 13, **dadurch gekennzeichnet, dass** die Querstreben (19) elektrisch leitend sind.

15. Strombegrenzer nach Anspruch 13, **dadurch gekennzeichnet, dass** die Querstreben (19) elektrisch isolierend sind.

16. Strombegrenzer nach einem der vorstehenden Ansprüche, **dadurch gekennzeichnet, dass** er außerdem eine Kühlvorrichtung umfasst, die ein Kühlfluid umfasst, das mit den elektrisch isolierenden Abstandshaltern (8) zwischen den Windungen der Spule (2) und mit den elektrisch leitenden Abstandshaltern (9) zwischen den supraleitenden Kabeln (5) in Kontakt steht.

17. Strombegrenzer nach einem der vorstehenden Ansprüche, **dadurch gekennzeichnet, dass** der leitende Abstandshalter (12) Sohlen (20) oder Sockel (21) aufweist, die die Kontaktoberfläche zu den beiden supraleitenden Kabeln (5) vergrößern.

18. Strombegrenzer nach einem der vorstehenden Ansprüche, **dadurch gekennzeichnet, dass** der leitende Abstandshalter (12) zusätzliche Wärmetauscher (22) zum Wärmeaustausch mit dem Kühlfluid umfasst.

## Claims

1. A superconducting current limiter (1) having at least one superconducting conductor (3) wound so as to form a coil (2) extending in a single plane and connecting a first electrical connection terminal (T1) to a second electrical connection terminal (T2), an electrically insulating spacer (8) being arranged between two turns of the coil (2), the superconducting conductor (3) consists of at least two separate superconducting cables (5) wound in parallel and whose ends are electrically connected by the first electrical connection terminal (T1) and by the second electrical connection terminal (T2), and an electrically conductive spacer (12) arranged between two of said separate superconducting cables (5), this electrically conductive spacer (12) being able to be traversed by a cooling fluid, **characterized by** the electrically conductive spacer (12) providing an electrical continuity between these two superconducting cables (5).

2. The current limiter as claimed in claim 1, **characterized in that** the coil (2) is a bifilar coil.

3. The current limiter as claimed in either one of the preceding claims, **characterized in that** it has an inter-turn space (6) between two windings of the superconducting conductor (3), and **in that** it has an inter-cable space (7) between two superconducting cables (5) of the same superconducting conductor (3), the electrically insulating spacer (8) being arranged along the inter-turn space (6) and the electrically conductive spacer (12) being arranged along the inter-cable space (7).

4. The current limiter as claimed in any one of the preceding claims, **characterized in that** the electrically conductive spacer (12) is made of metal.

5. The current limiter as claimed in one of claims 1 to 3, **characterized in that** the electrically conductive spacer (12) consists of a semiconductor material.

6. The current limiter as claimed in claim 5, **characterized in that** the metal of the electrically conductive spacer (12) has a thermal conductivity greater than 150 W/m/K.

7. The current limiter as claimed in one of the preceding claims, **characterized in that** the electrically conductive spacer (12) is in the form of a folded or corrugated strip.

8. The current limiter as claimed in any one of the preceding claims, **characterized in that** the electrically conductive spacer (12) has flow gaps (13) for the cooling fluid.

9. The current limiter as claimed in any one of the preceding claims, **characterized in that** the electrically conductive spacer (12) and the electrically insulating spacer (8) have substantially the same shape.

10. The current limiter as claimed in any one of the preceding claims, **characterized in that** the electrically conductive spacer (12) exhibits anisotropic electrical conduction behavior that promotes electrical conduction between said two superconducting cables (5).

11. The current limiter as claimed in claim 10, **characterized in that** the electrically conductive spacer (12) is discontinuous and formed of discrete spacers (15).

12. The current limiter as claimed in claim 10, **characterized in that** the electrically conductive spacer (12) is formed by juxtaposing conductive spacers (16) and insulating spacers (17).

13. The current limiter as claimed in claim 10, **characterized in that** the electrically conductive spacer (12) has metal bridges (18) between said two superconducting cables (5) and struts (19) arranged between these metal bridges.

14. The current limiter as claimed in claim 13, **characterized in that** the struts (19) are electrically conductive.

15. The current limiter as claimed in claim 13, **characterized in that** the struts (19) are electrically insulating.

16. The current limiter as claimed in any one of the preceding claims, **characterized in that** it furthermore has a cooling device comprising a cooling fluid in contact with the electrically insulating spacers (8), between the turns of the coil (2), and with the electrically conductive spacers (9), between the superconducting cables (5).

17. The current limiter as claimed in any one of the preceding claims, **characterized in that** the conductive spacer (12) has soles (20) or bases (21) that increase the contact area with the two superconducting cables (5).

18. The current limiter as claimed in any one of the preceding claims, **characterized in that** the conductive spacer (12) has additional heat exchangers (22) for exchanging heat with the cooling fluid.
